(19) Europäisches Patentamt
European Patent Office
Office européen des brevets

(11) **EP 4 394 413 A1**

(12) **EUROPEAN PATENT APPLICATION**
published in accordance with Art. 153(4) EPC

(43) Date of publication:
**03.07.2024 Bulletin 2024/27**

(51) International Patent Classification (IPC):
**G01R 31/392** (2019.01)    **G01R 31/36** (2020.01)

(21) Application number: **22888838.4**

(86) International application number:
**PCT/CN2022/097986**

(22) Date of filing: **10.06.2022**

(87) International publication number:
**WO 2023/077802 (11.05.2023 Gazette 2023/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.11.2021 CN 202111314620**

(71) Applicant: **BEIJING NATIONAL NEW ENERGY VEHICLE TECHNOLOGY INNOVATION CENTER CO., LTD.**
**Beijing 102600 (CN)**

(72) Inventors:
• **WANG, Chen**
  **Beijing 102600 (CN)**
• **WANG, Zexing**
  **Beijing 102600 (CN)**
• **ZONG, Lei**
  **Beijing 102600 (CN)**
• **ZOU, Guangcai**
  **Beijing 102600 (CN)**
• **YUAN, Chengyin**
  **Beijing 102600 (CN)**

(74) Representative: **Wächter, Jochen**
**Kroher-Strobel**
**Rechts- und Patentanwälte PartmbB**
**Bavariaring 20**
**80336 München (DE)**

(54) **BATTERY CAPACITY CHARACTERISTIC EXTRACTION METHOD**

(57) A battery capacity characteristic extraction method, comprising: acquiring state of charge, total voltage, a lowest battery cell voltage value and a highest battery cell voltage value at each moment in charging process and discharging process of a power battery when current is lower than a current threshold and a torque of a driving motor is lower than a torque threshold; acquiring a total voltage and state of charge table on the basis of the state of charge and the total voltage at each moment; acquiring a battery cell voltage and state of charge table; acquiring a first-order internal resistance table of the charging process and a first-order internal resistance table of driving process on the basis of the total voltage and state of charge table; and acquiring charging capacity degradation rate on the basis of the battery cell voltage and state of charge table. According to the present invention, the $SOH_C$ is determined through the charging and discharging state characteristics of a vehicle in different time periods. The $SOH_C$ is accurate, the first-order internal resistance table of the charging process and the first-order internal resistance table of the driving process are corrected according to the OCV-SOC table, and an accurate internal resistance value and SOC for calculating $SOH_R$ are provided.

acquiring a state of charge, a total voltage, a lowest battery cell voltage value and a highest battery cell voltage value at each moment in a charging process and a discharging process of a power battery when current is lower than a current threshold and a torque of a driving motor is lower than a torque threshold — step 1

acquiring a total voltage and state of charge table on the basis of the state of charge and the total voltage at each moment — step 2

acquiring a battery cell voltage and state of charge table on the basis of the state of charge, the lowest battery cell voltage value and the highest battery cell voltage value at each moment — step 3

acquiring a first-order internal resistance table of the charging process and a first-order internal resistance table of a driving process on the basis of the total voltage and state of charge table — step 4

acquiring a charging capacity degradation rate on the basis of the battery cell voltage and state of charge table — step 5

Fig.1

**Description**

**FIELD OF TECHNOLOGY**

The present invention relates to the technical field of power battery, more specifically, relates to a method and system for extracting battery capacity characteristic.

**BACKGROUND**

The power battery is an important component of new energy vehicles, so it is necessary to know the data characteristics of the charging process, driving process, and parking process of the power battery. Usually, the data characteristics that characterize the charging process, driving process, and parking process of the power battery mainly include the battery capacity characteristics, including capacity degradation rate ($SOH_C$) and internal resistance aging ($SOH_R$). However, due to the complex aging mechanism and numerous influencing factors of the power battery, it is difficult to estimate the battery capacity degradation rate ($SOH_C$) and internal resistance aging ($SOH_R$) during the use of the power battery. The current mainstream method for estimating $SOH_C$ is based on the integration of ampere hours and the difference in state of charge (SOC) to estimate the current maximum remaining capacity at full SOC, and thus estimate $SOH_C$ of the battery. However, state of charge (SOC) is obtained based on equivalent circuit models and initial test parameters of the battery, and due to battery aging, the initial test parameters of the battery cannot be continuously used for SOC estimation throughout its entire lifecycle, resulting in inaccurate SOC estimation. The accuracy of SOC estimation for the entire lifecycle of the battery also determines the accuracy of battery SOH estimation. SOH estimation requires accurate extraction of the current and SOC at each sampling point at each moment. However, due to the large deviations between the actual internal resistance, capacity, and testing parameters of the battery in the later stages of its life, as well as the deterioration of battery cell consistency, accurate SOC cannot be obtained, and therefore $SOH_C$ cannot be accurately calculated.

Due to the significant correlation between battery internal resistance and battery temperature, charging and discharging rate, and SOC, and the small values that are difficult to estimate, there is currently no mature $SOH_R$ estimation algorithm.

Therefore, there is a special need for a method that can accurately calculate $SOH_C$ and accurate SOC required for calculating $SOH_R$.

**SUMMARY**

The purpose of the present invention is to propose a method that can accurately calculate $SOH_C$ and accurate SOC required for calculating $SOH_R$.

To achieve the above objective, the present invention provides a battery capacity characteristic extraction method, comprising: acquiring state of charge, total voltage, a lowest battery cell voltage value and a highest battery cell voltage value at each moment in charging process and discharging process of a power battery when current is lower than a current threshold and a torque of a driving motor is lower than a torque threshold; acquiring a total voltage and state of charge table on the basis of the state of charge and the total voltage at each moment; acquiring a battery cell voltage and state of charge table on the basis of the state of charge, the lowest battery cell voltage value and the highest battery cell voltage value at each moment; acquiring a first-order internal resistance table of the charging process and a first-order internal resistance table of driving process on the basis of the total voltage and state of charge table; and acquiring charging capacity degradation rate on the basis of the battery cell voltage and state of charge table.

Preferably, the total voltage and state of charge table is acquired by the following steps: drawing a first coordinate system with the state of charge as horizontal coordinate and the total voltage as vertical coordinate, and marking the state of charge and the total voltage at each moment in the first coordinate system; sequentially connecting marked points to obtain a first curve, fitting the first curve and acquiring the total voltage and state of charge table according to fitted relationship.

Preferably, the battery cell voltage and state of charge table is acquired by the following steps: drawing a second coordinate system with the state of charge as horizontal coordinate and the battery cell voltage as vertical coordinate, and marking the state of charge, the lowest battery cell voltage value and the highest battery cell voltage value at each moment in the second coordinate system; sequentially connecting marked points to obtain a second curve, fitting the second curve and acquiring the battery cell voltage and state of charge table according to fitted relationship.

Preferably, the first-order internal resistance table of the charging process is acquired by the following steps: calculating first-order internal resistance values of the charging process under different first initial state of charge, charging current, number of cycles, and charging static voltage, wherein the charging static voltage is an average value of voltage in a state of stopping charging and voltage in a static state before charging; establishing a first relationship table of the first-order internal resistance value of the charging process and the corresponding first initial state of charge, charging current, number of cycles, and charging static voltage; based on the total voltage and state of charge table, using the charging static voltage as the total voltage, and acquiring a first modified state of charge corresponding to the charging static voltage; modifying the first initial state of charge in the first relationship table to the modified state of charge to obtain the first-order internal resistance table of the charging process.

Preferably, the first-order internal resistance value of the charging process is calculated by the following formulas:

$$\begin{cases} R_{I,SOC,N}^{charge-s} = \dfrac{U_{t_{charge\_start}-1} - U_{t_{charge\_start}}}{I} \\ R_{I,SOC,N}^{charge-e} = \dfrac{U_{t_{charge\_end}} - U_{t_{charge\_end}+1}}{I} \end{cases}$$

wherein, $R_{I,SOC,N}^{charge-s}$ is the first-order internal resistance value at the moment of start of charging, $R_{I,SOC,N}^{charge-e}$ is the first-order internal resistance value at the moment of end of charging, $U_{t_{charge\_start}-1}$ is voltage at the moment just before the start of charging, $U_{t_{chaarge\_start}}$ is voltage at the moment of the start of charging, $U_{t_{charge\_end}}$ is voltage at the moment of the end of charging, $U_{t_{charge\_end}+1}$ is voltage at the moment just after the end of charging, $t_{charge\_start-1}$ is the moment just before the start of charging, $t_{charge\_start}$ is the moment of the start of charging, $t_{charge\_end}$ is the moment of the end of charging, and $t_{drive\_start+1}$ is the moment just after the end of charging, I is the charging current.

Preferably, the first-order internal resistance table of the driving process is acquired by the following steps: calculating first-order internal resistance values of the driving process under different second initial state of charge, discharging current, number of cycles, and driving static voltage, wherein the driving static voltage is an average value of voltage in a state of stopping driving and voltage in a static state before driving; establishing a second relationship table of the first-order internal resistance value of the driving process and the corresponding second initial state of charge, discharging current, number of cycles, and driving static voltage; based on the total voltage and state of charge table, using the driving static voltage as the total voltage, and acquiring a second modified state of charge corresponding to the driving static voltage; modifying the second initial state of charge in the second relational table to the second modified state of charge to obtain the first-order internal resistance table of the driving process.

Preferably, the first-order internal resistance value of the driving process is calculated by the following formulas:

$$R_{I,SOC,N}^{drive-s} = \frac{U_{t_{drive\_start}-1} - U_{t_{drive\_start}}}{I}$$

$$R_{I,SOC,N}^{drive-e} = \frac{U_{t_{drive\_end}} - U_{t_{drive\_end}+1}}{I}$$

wherein, $R_{I,SOC,N}^{drive-s}$ is the first-order internal resistance value at the moment of start of driving, $R_{I,SOC,N}^{drive-e}$ is the first-order internal resistance value at the moment of end of driving, $U_{t_{drive\_start}-1}$ is voltage at the moment just before the start of driving, $U_{t_{drive\_start}}$ is voltage at the moment of the start of driving, $U_{t_{drive\_end}}$ is voltage at the moment of the end of driving, $U_{t_{drive\_end}+1}$ is the voltage at the moment just after the end of driving, $t_{drive\_start-1}$ is the moment just before the start of driving, $t_{drive\_start}$ is the moment of the start of driving, $t_{drive\_end}$ is the moment of the end of driving, $t_{drive\_end+1}$ is the moment just after the end of driving, I is the discharging current.

Preferably, the charging capacity degradation rate is acquired by the following steps: determining the state of charge in a static state before the start of charging based on the battery cell voltage and state of charge table and the lowest battery cell voltage value in the static state before the start of charging; determining the state of charge in a static state after the end of charging based on the battery cell voltage and state of charge table and the highest battery cell voltage value in the static state at the end of charging; determining the moment of the static state before the start of charging and the moment of the static state after the end of charging based on the state of charge of the power battery at each moment; calculating the charging capacity degradation rate based on the moment of the static state before the start of charging and the moment of the static state after the end of charging.

Preferably, the charging capacity degradation rate is calculated by the following formulas:

$$\begin{cases} Q_{SOC_{charge\_start},SOC_{charge\_end}} = \int_{t_{SOC_{charge\_start}}}^{t_{SOC_{charge\_end}}} i(t)dt \\[2em] Q_{now} = \dfrac{Q_{SOC_{charge\_start},SOC_{charge\_end}}}{\Delta SOC} \\[2em] SOH_{c1} = \dfrac{Q_{now}}{Q_{ini}} \times 100\% \end{cases}$$

wherein, $Q_{SOC_{charge\_start},SOC_{charge\_end}}$ is a cumulative capacity value from the moment of the static state before the start of charging to the moment of the static state after the end of charging, $SOC_{charge\_start}$ is the state of charge in the static state before the start of charging, $SOC_{charge\_end}$ is the state of charge in the static state after the end of charging, $t_{SOC_{charge\_start}}$ is the moment of the static state before the start of charging, $t_{SOC_{charge\_end}}$ is the moment of the static state at the end of charging, $Q_{now}$ is current maximum available capacity of the battery, $Q_{ini}$ is an initial maximum available capacity of the battery, and $SOH_{c1}$ is the charging capacity degradation rate, i is current.

Preferably, the discharging capacity degradation rate is calculated by the following formula:

$$SOH_{c2} = \frac{M_{drive\_end} - M_{drive\_start}}{M_{NEDC}}$$

wherein, $SOH_{c2}$ is the discharging capacity degradation rate, $M_{drive\_end}$ is mileage at the end of driving, $M_{drive\_start}$ is mileage at the start of driving, $M_{NEDC}$ is mileage duration.

The beneficial effect of the present invention is that: the battery capacity characteristic extraction method of the present invention does not require testing data of the battery before boarding, the $SOH_C$ is determined based on driving data and the charging and discharging state characteristics of the vehicle at different time cycles. The $SOH_C$ is accurate, and the first-order internal resistance table of the charging process and the first-order internal resistance table of the driving process are corrected based on the OCV-SOC table to provide accurate internal resistance values and SOC for calculating $SOH_R$.

**BRIEF DESCRIPTION OF THE DRAWINGS**

By providing a more detailed description of exemplary embodiments of the present invention in conjunction with the accompanying drawings, the aforementioned and other objects, features, and advantages of the present invention will become more apparent. Among them, in exemplary embodiments of the present invention, the same reference numerals typically represent the same components.

Fig. 1 shows a flowchart of the battery capacity characteristic extraction method according to an embodiment of the present invention.
Fig. 2 shows a figure of the total voltage and state of charge table of the battery capacity characteristic extraction method according to an embodiment of the present invention.
Fig. 3 shows a figure of the battery cell voltage and state of charge table of the battery capacity characteristic extraction method according to an embodiment of the present invention.
Fig. 4 shows a flowchart of the battery capacity characteristic extraction method according to another embodiment of the present invention.

**DESCRIPTION OF THE EMBODIMENTS**

Below, preferred embodiments of the present invention will be described in more detail with reference to the accompanying drawings. Although preferred embodiments of the present invention are shown in the accompanying drawings, it should be understood that the present invention can be implemented in various forms and should not be limited by the embodiments described herein. On the contrary, these implementation methods are provided to make the present invention more thorough and complete, and to fully convey the scope of the present invention to those skilled in the art.

According to the present invention, a battery capacity characteristic extraction method, characterized in that, comprising: acquiring state of charge, total voltage, a lowest battery cell voltage value and a highest battery cell voltage value at each moment in charging process and discharging process of a power battery when current is lower than a current threshold and a torque of a driving motor is lower than a torque threshold; acquiring a total voltage and state of charge table on the basis of the state of charge and the total voltage at each moment; acquiring a battery cell voltage and state of charge table on the basis of the state of charge, the lowest battery cell voltage value and the highest battery cell voltage value at each moment; acquiring a first-order internal resistance table of the charging process and a first-order internal resistance table of a driving process on the basis of the total voltage and state of charge table; and acquiring charging capacity degradation rate on the basis of the battery cell voltage and state of charge table.

Specifically, capture all fields in the charging process and discharging process when the current is less than 0.1C and the torque of the driving motor is less than 20Nm, and record SOC, total voltage, lowest battery cell voltage value, and highest battery cell voltage value of the field. By traversing the overall data, the total voltage OCV table and cell voltage OCV table under different SOC, namely the total voltage and state of charge table and the battery cell voltage and state of charge table, which are referred to as the "total voltage SOC-OCV table" and "battery cell voltage SOC-OCV table", are obtained. After the first-order internal resistance table of the charging process and the first-order internal resistance table of the driving process are obtained through calculation, based on the charging static voltage and driving static voltage, the corrected SOC is obtained based on the total voltage SOC-OCV table, and then the SOC in the first-order internal resistance table of the charging process and the SOC in the first-order internal resistance table of the driving process are modified. By using the battery cell voltage SOC-OCV table, the state of charge of the static state before the start of charging and the state of charge of the static state after the end of charging are obtained, and the charging capacity degradation rate is calculated.

According to an exemplary implementation, the battery capacity characteristic extraction method does not require testing data of the battery before boarding, the $SOH_C$ is determined based on driving data and the charging and discharging state characteristics of the vehicle at different time cycles. The $SOH_C$ is accurate, and the first-order internal resistance table of the charging process and the first-order internal resistance table of the driving process are corrected based on the OCV-SOC table to provide accurate internal resistance values and SOC for calculating $SOH_R$.

As the preferred solution, the total voltage and state of charge table is acquired through the following steps: drawing a first coordinate system with the state of charge as horizontal coordinate and the total voltage as vertical coordinate, and marking the state of charge and the total voltage at each moment in the first coordinate system; sequentially connecting marked points to obtain a first curve, fitting the first curve and acquiring the total voltage and state of charge table according to fitted relationship, also known as the "total voltage SOC-OCV table".

Specifically, capture all fields when charging or discharging current is less than 0.1C and driving motor torque is less than 20Nm, and record the SOC, total voltage, lowest battery cell voltage, and highest battery cell voltage of these fields. By traversing the overall data, the total voltage OCV under different SOC is obtained. The first coordinate system is plotted with the state of charge as the abscissa and the total voltage as the ordinate. The state of charge and total voltage at each moment are marked in the first coordinate system. The marked points are connected into a curve, and the curve is fitted to obtain the fitting relationship of the curve. Based on the fitting relationship, the total voltage and state of charge table is generated.

As the preferred solution, the battery cell voltage and state of charge table is acquired by the following steps: drawing a second coordinate system with the state of charge as horizontal coordinate and the battery cell voltage as vertical coordinate, and marking the state of charge, the lowest battery cell voltage value and the highest battery cell voltage value at each moment in the second coordinate system; sequentially connecting marked points to obtain a second curve, fitting the second curve and acquiring the battery cell voltage and state of charge table according to fitted relationship.

Specifically, capture all fields when charging or discharging current is less than 0.1C and driving motor torque is less than 20Nm, and record the SOC, total voltage, lowest battery cell voltage, and highest battery cell voltage of these fields. By traversing the overall data, the lowest and highest values of battery cell voltage under different SOC are obtained. The first coordinate system is plotted with the state of charge as the abscissa and the battery cell voltage as the ordinate. The state of charge and battery cell voltage at each moment are marked in the first coordinate system. The marked points are connected to form a curve, and the curve is fitted to obtain the fitting relationship of the curve. Based on the fitting relationship, a battery cell voltage and state of charge table, also known as a "battery cell voltage SOC-OCV table", is generated.

As the preferred solution, the first-order internal resistance table of the charging process is acquired by the following steps:

calculating first-order internal resistance values of the charging process under different first initial state of charge, charging current, number of cycles, and charging static voltage, wherein the charging static voltage is an average value of voltage in a state of stopping charging and voltage in a static state before charging; establishing a first relationship table of the first-order internal resistance value of the charging process and the corresponding first initial state of charge, charging current, number of cycles, and charging static voltage; based on the total voltage and state of charge table, using the charging static voltage as the total voltage, and acquiring a first modified state of charge corresponding to the charging static voltage; modifying the first initial state of charge in the first relationship table to the modified state of charge to obtain the first-order internal resistance table of the charging process.

Specifically, the SOC corresponding to the first-order internal resistance table of the charging process is corrected using the "total voltage SOC-OCV table". The specific method is to use the static voltage before the charging start point as the OCV voltage, compare it with the "total voltage SOC-OCV table" to obtain the corrected SOC of the charging start process, and replace the corrected SOC of the charging start process with the SOC in the first-order internal resistance table of the charging process.

The time of the first row is denoted as $t_{start}$, the time of the last row is denoted as $t_{end}$, and the initial capacity is denoted as $Q_{ini}$, and the number of battery cycles during the historical process is calculated according to the formula:

$$N = \frac{\int_{t_{start}}^{t_{end}} I dt}{Q_{ini}} \ (I > 0)$$

Take the moment when the charging ampere hour is an integer multiple of the initial capacity, use this moment as the initial moment of the cycle, and the time data in the previous row as the ending moment of the previous cycle. If the charging data is severely missing, the number of cycles will be calculated based on the number of kilometers. Include charging and driving events in each cycle according to the time interval of the cycles. If the charging or driving event crosses the ending time of a cycle, the number of cycles that the event belongs to will be distinguished based on the time proportion of the event in the two cycles.

As the preferred solution, the first-order internal resistance value of the charging process is calculated by the following formulas:

$$\begin{cases} R_{I,SOC,N}^{charge-s} = \dfrac{U_{t_{charge\_start}-1} - U_{t_{charge\_start}}}{I} \\ R_{I,SOC,N}^{charge-e} = \dfrac{U_{t_{charge\_end}} - U_{t_{charge\_end}+1}}{I} \end{cases}$$

wherein, $R_{I,SOC,N}^{charge-s}$ is the first-order internal resistance value at the moment of start of charging, $R_{I,SOC,N}^{charge-e}$ is the first-order internal resistance value at the moment of end of charging, $U_{t_{charge\_start}-1}$ is voltage at the moment just before the start of charging, $U_{t_{charge\_start}}$ is voltage at the moment of the start of charging, $U_{t_{charge\_end}}$ is voltage at the moment of the end of charging, $U_{t_{charge\_end}+1}$ is voltage at the moment just after the end of charging, $t_{chargestart-1}$ is the moment just before the start of charging, $t_{charge\_start}$ is the moment of the start of charging, $t_{charge\_end}$ is the moment of the end of charging, and $t_{drive\_start+1}$ is the moment just after the end of charging, I is the charging current.

Specifically, the determination of the first-order internal resistance is: within every 50 cycles, retrieve fields with continuous recording time longer than 60 seconds and including the starting or ending time point of charging ($t_{charge\_start}$, $t_{charge\_end}$) through identification bits such as "total current", "SOC", "charging state", "vehicle state", etc. The first-order internal resistance values under different SOC, charging current, number of cycles, and static voltage are calculated by the following formulars:

$$\begin{cases} R_{I,SOC,N}^{charge-s} = \dfrac{U_{t_{charge\_start}-1} - U_{t_{charge\_start}}}{I} \\[3mm] R_{I,SOC,N}^{charge-e} = \dfrac{U_{t_{charge\_end}} - U_{t_{charge\_end}+1}}{I} \end{cases}$$

Based on historical data, form a first-order internal resistance table of the charging process, and record the average value of voltage in a state of stopping charging and voltage in a static state before charging as the static voltage.

As a preferred solution, the first-order internal resistance table of the driving process is acquired by the following steps: calculating first-order internal resistance values of the driving process under different second initial state of charge, discharging current, number of cycles, and driving static voltage, wherein the driving static voltage is an average value of voltage in a state of stopping driving and voltage in a static state before driving; establishing a second relationship table of the first-order internal resistance value of the driving process and the corresponding second initial state of charge, discharging current, number of cycles, and driving static voltage; based on the total voltage and state of charge table, using the driving static voltage as the total voltage, and acquiring a second modified state of charge corresponding to the driving static voltage; modifying the second initial state of charge in the second relational table to the second modified state of charge to obtain the first-order internal resistance table of the driving process.

Specifically, the SOC corresponding to the first-order internal resistance table during driving is corrected using the "total voltage SOC-OCV table". The specific method is to use the static voltage before the starting point of driving as the OCV voltage, and compare it with the "total voltage SOC-OCV table" to obtain the corrected SOC of the starting process of driving. The SOC in the first-order internal resistance table of the driving process is replaced by the corrected SOC of the starting process of driving.

As a preferred solution, the first-order internal resistance value of the driving process is calculated by the following formulas:

$$R_{I,SOC,N}^{drive-s} = \frac{U_{t_{drive\_start}-1} - U_{t_{drive\_start}}}{I}$$

$$R_{I,SOC,N}^{drive-e} = \frac{U_{t_{drive\_end}} - U_{t_{drive\_end}+1}}{I}$$

wherein, $R_{I,SOC,N}^{drive-s}$ is the first-order internal resistance value at the moment of start of driving, $R_{I,SOC,N}^{drive-e}$ is the first-order internal resistance value at the moment of end of driving, $U_{t_{drive\_start}-1}$ is voltage at the moment just before the start of driving, $U_{t_{drive\_start}}$ is voltage at the moment of the start of driving, $U_{t_{drive\_end}}$ is voltage at the moment of the end of driving, $U_{t_{drive\_end}+1}$ is the voltage at the moment just after the end of driving, $t_{drive\_start-1}$ is the moment just before the start of driving, $t_{drive\_start}$ is the moment of the start of driving, $t_{drive\_end}$ is the moment of the end of driving, $t_{drive\_end+1}$ is the moment just after the end of driving, I is the discharging current.

Specifically, within every 50 cycles, retrieve fields with continuous recording time longer than 60 seconds and including the starting or ending time point of driving ($t_{drive\_start}$, $t_{drive\_end}$) through identification bits such as "total current", "SOC", "charging state", "vehicle state", etc. The first-order internal resistance values under different SOC, charging current, number of cycles, and static voltage are calculated by the following formulars:

$$\begin{cases} R_{I,SOC,N}^{drive-s} = \dfrac{U_{t_{drive\_start}-1} - U_{t_{drive\_start}}}{I} \\[3mm] R_{I,SOC,N}^{drive-e} = \dfrac{U_{t_{drive\_end}} - U_{t_{drive\_end}+1}}{I} \end{cases}$$

Based on historical data, form a first-order internal resistance table of the driving process, and record the average value of voltage in a state of stopping driving and voltage in a static state before driving as the static voltage.

As a preferred solution, the charging capacity degradation rate is acquired by the following steps: determining the state of charge in a static state before the start of charging based on the battery cell voltage and state of charge table and the lowest battery cell voltage value in the static state before the start of charging; determining the state of charge in a static state after the end of charging based on the battery cell voltage and state of charge table and the highest battery cell voltage value in the static state at the end of charging; determining the moment of the static state before the start of charging and the moment of the static state after the end of charging based on the state of charge of the power battery at each moment; calculating the charging capacity degradation rate based on the moment of the static state before the start of charging and the moment of the static state after the end of charging.

As a preferred solution, the charging capacity degradation rate is calculated by the following formulas:

$$
\begin{cases}
Q_{SOC_{charge\_start}, SOC_{charge\_end}} = \int_{t_{SOC_{charge\_start}}}^{t_{SOC_{charge\_end}}} i(t)dt \\
Q_{now} = \dfrac{Q_{SOC_{charge\_start}, SOC_{charge\_end}}}{\Delta SOC} \\
SOH_{c1} = \dfrac{Q_{now}}{Q_{ini}} \times 100\%
\end{cases}
$$

wherein, $Q_{SOC_{charge\_start}, SOC_{charge\_end}}$ is a cumulative capacity value from the moment of the static state before the start of charging to the moment of the static state after the end of charging, $SOC_{charge\_start}$ is the state of charge in the static state before the start of charging, $SOC_{charge\_end}$ is the state of charge in the static state after the end of charging, $t_{SOC_{charge\_start}}$ is the moment of the static state before the start of charging, $t_{SOC_{charge\_end}}$ is the moment of the static state at the end of charging, $Q_{now}$ is current maximum available capacity of the battery, $Q_{ini}$ is an initial maximum available capacity of the battery, and $SOH_{c1}$ is the charging capacity degradation rate, i is current.

Specifically, during the charging process, the SOC at the start of charging is determined by the "battery cell voltage SOC-OCV Table" and the lowest value of the battery cell voltage in the static state before the start of charging, denoted as $SOC_{charge\_start}$. The SOC at the end of charging is determined by the "battery cell voltage SOC-OCV Table" and the highest value of the battery cell voltage in the static state at the end of charging, denoted as $SOC_{charge\_start}$. Integrate the charging capacity during each charging process using the below formula and calculate the discharging capacity degradation rate:

$$
\begin{cases}
Q_{SOC_{charge\_start}, SOC_{charge\_end}} = \int_{t_{SOC_{charge\_start}}}^{t_{SOC_{charge\_end}}} i(t)dt \\
Q_{now} = \dfrac{Q_{SOC_{charge\_start}, SOC_{charge\_end}}}{\Delta SOC} \\
SOH_{c1} = \dfrac{Q_{now}}{Q_{ini}} \times 100\%
\end{cases}
$$

As a preferred solution, the discharging capacity degradation rate is calculated by the following formula:

$$
SOH_{c2} = \frac{M_{drive\_end} - M_{drive\_start}}{M_{NEDC}}
$$

wherein, $SOH_{c2}$ is the discharging capacity degradation rate, $M_{drive\_end}$ is mileage at the end of driving, $M_{drive\_start}$ is mileage at the start of driving, $M_{NEDC}$ is mileage duration.

Specifically, the mileage at the start of driving and the mileage at the end of driving of each driving event are recorded as $M_{drive\_start}$ and $M_{drive\_end}$, and the discharging capacity degradation rate is approximately calculated by the

formula of:

$$SOH_{c2} = \frac{M_{drive\_end} - M_{drive\_start}}{M_{NEDC}}$$

This application also extracts other characteristic data and calculates the characteristic sensitivity of capacity degradation. The specific steps are as follows:
Randomly select data from 1000 vehicles of this model and perform the following characteristic extraction work:

1. Complete the capacity estimation point data according to the steps of obtaining the number of battery cycles, and distinguish the data by the number of cycles of every 50 cycles which are denoted as $SOH_{N,k}$, wherein N=50, 100, 150, ... , k is the vehicle number, k=1,2,..., 1000.

2. Record the median current of each driving event and each charging event as $I_{drive}^{i}$ and $I_{charge}^{j}$ , wherein i and j refer to the i-th driving event and j-th charging event, respectively.

3. Record the median temperature of each driving event and each charging event as $T_{drive}^{i}$ and $T_{charge}^{j}$ , wherein i and j refer to the i-th driving event and j-th charging event, respectively.
4. Record the discharging depth and charging depth of each driving event and charging event, denoted as $DOD^{i}$ and $DOC^{j}$, wherein i and j refer to the i-th driving event and j-th charging event, respectively.
5. Record the median pressure difference of each driving event and charging event, denoted as $dV^{i}$ and $dV^{j}$, wherein i and j refer to the i-th driving event and j-th charging event, respectively.
6. Record the median temperature difference of each driving event and charging event, denoted as $dT^{i}$ and $dT^{j}$, wherein i and j refer to the i-th driving event and j-th charging event, respectively.
7. Record the first-order internal resistance of each driving event and each charging event through the "first-order internal resistance table of the charging process" and the "first-order internal resistance table of the driving process", denoted as $R_{I,SOC,N}^{j}$ and $R_{I,SOC,N}^{i}$ , wherein i and j refer to the i-th driving event and j-th charging event, respectively.
8. Extract other characteristics, including but not limited to temperature rise value, median vehicle speed, median pressure difference, median temperature difference, etc. for each charging event and each driving event.
9. Record characteristic data every 50 cycles, train characteristic sensitivity models for capacity degradation under different cycles by random forest or other machine learning algorithms, calculate characteristic importance based on the model at each cycle stage, and thus calculate the degree of influence of different characteristics on capacity degradation. Finally, summarize the relationship between the characteristic sensitivity of capacity degradation under different cycles, denoted as:

$SOH_{c,N,k}$

$$= f\left(N, I_{drive}^{i,k}, I_{charge}^{j,k}, T_{drive}^{i,k}, T_{charge}^{j,k}, DOD^{i,k}, DOC^{j,k}, dV^{i}, dV^{j}, dT^{i}, dT^{j}, R_{I,SOC,N}^{i,k}, R_{I,SOC,N}^{j,k} \cdots \right), \ N$$

$$= 50, 100, 150, \ldots, k = 1, 2, \ldots, 1000$$

10. Based on the sensitivity information table obtained from the data of 1000 vehicles of this model, modify the estimated capacity of a single vehicle under different cycle times as follows:
the above characteristic sensitivity relationship is regularized, normalized, and decomposed to obtain the weight parameters of SOHc for different cycles which are corrected by current, temperature, and charging depth, denoted as $x_{I}^{N}, x_{T}^{N}, x_{DOC}^{N}$ . The capacity degradation rate of a single vehicle is denoted as

$$SOH_{c,N}^{'} = SOH_{c,N} * (x_{I}^{N} + x_{T}^{N} + x_{DOC}^{N})$$

. If there are other characteristics with high sensitivity, they can also be added to this formula.

At this point, several characteristics of each charging event and several characteristics of each driving event are obtained.

Derive a method for obtaining battery aging characteristics and quantify the sensitivity of aging characteristics using machine learning algorithms to improve the accuracy of battery capacity degradation rate estimation.

Embodiment 1

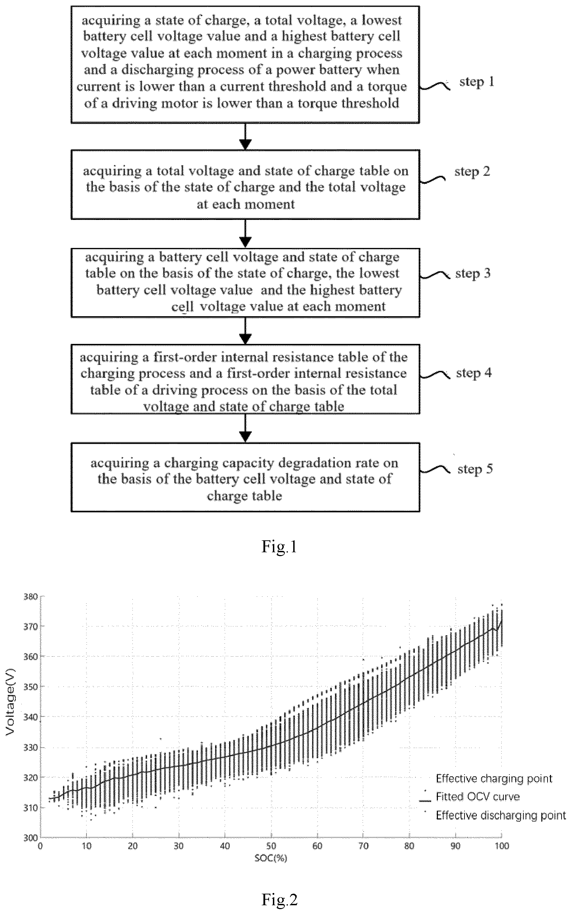

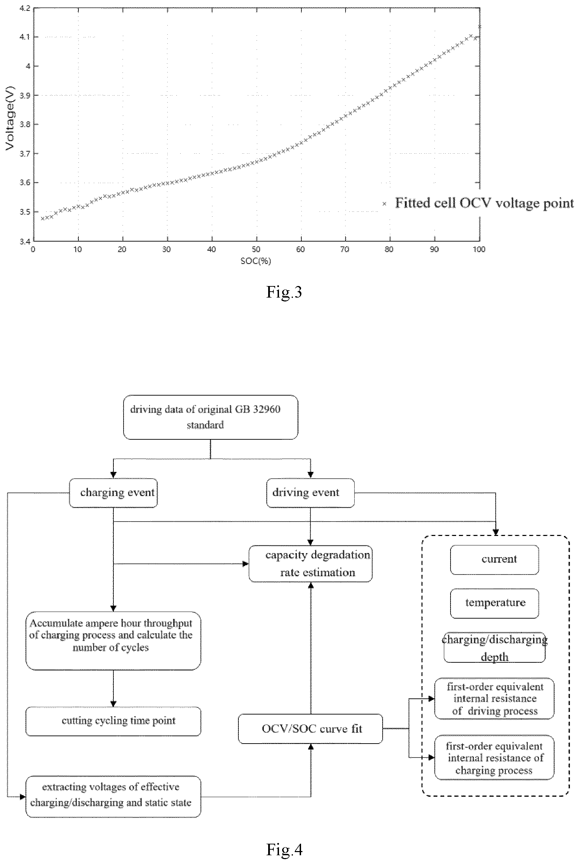

Fig. 1 shows a flowchart of the battery capacity characteristic extraction method according to an embodiment of the present invention. Fig. 2 shows a figure of the total voltage and state of charge table of the battery capacity characteristic extraction method according to an embodiment of the present invention. Fig. 3 shows a figure of the battery cell voltage and state of charge table of the battery capacity characteristic extraction method according to an embodiment of the present invention. Fig. 4 shows a flowchart of the battery capacity characteristic extraction method according to another embodiment of the present invention.

As illustrated in Fig.1, Fig.2, Fig.3 and Fig.4, the battery capacity characteristic extraction method, comprising:

Step 1: acquiring state of charge, total voltage, a lowest battery cell voltage value and a highest battery cell voltage value at each moment in charging process and discharging process of a power battery when current is lower than a current threshold and a torque of a driving motor is lower than a torque threshold;

step 2: acquiring a total voltage and state of charge table on the basis of the state of charge and the total voltage at each moment;

step 3: acquiring a battery cell voltage and state of charge table on the basis of the state of charge, the lowest battery cell voltage value and the highest battery cell voltage value at each moment;

step 4: acquiring a first-order internal resistance table of the charging process and a first-order internal resistance table of driving process on the basis of the total voltage and state of charge table;

step 5: acquiring charging capacity degradation rate on the basis of the battery cell voltage and state of charge table.

The total voltage and state of charge table is acquired by the following steps: drawing a first coordinate system with the state of charge as horizontal coordinate and the total voltage as vertical coordinate, and marking the state of charge and the total voltage at each moment in the first coordinate system; sequentially connecting marked points to obtain a first curve, fitting the first curve and acquiring the total voltage and state of charge table according to fitted relationship.

The battery cell voltage and state of charge table is acquired by the following steps: drawing a second coordinate system with the state of charge as horizontal coordinate and the battery cell voltage as vertical coordinate, and marking the state of charge, the lowest battery cell voltage value and the highest battery cell voltage value at each moment in the second coordinate system; sequentially connecting marked points to obtain a second curve, fitting the second curve and acquiring the battery cell voltage and state of charge table according to fitted relationship.

The first-order internal resistance table of the charging process is acquired by the following steps: calculating first-order internal resistance values of the charging process under different first initial state of charge, charging current, number of cycles, and charging static voltage, wherein the charging static voltage is an average value of voltage in a state of stopping charging and voltage in a static state before charging; establishing a first relationship table of the first-order internal resistance value of the charging process and the corresponding first initial state of charge, charging current, number of cycles, and charging static voltage; based on the total voltage and state of charge table, using the charging static voltage as the total voltage, and acquiring a first modified state of charge corresponding to the charging static voltage; modifying the first initial state of charge in the first relationship table to the modified state of charge to obtain the first-order internal resistance table of the charging process.

The first-order internal resistance value of the charging process is calculated by the following formulas:

$$\begin{cases} R_{I,SOC,N}^{charge-s} = \dfrac{U_{t_{charge\_start}-1} - U_{t_{charge\_start}}}{I} \\ R_{I,SOC,N}^{charge-e} = \dfrac{U_{t_{charge\_end}} - U_{t_{charge\_end}+1}}{I} \end{cases}$$

wherein, $R_{I,SOC,N}^{charge-s}$ is the first-order internal resistance value at the moment of start of charging, $R_{I,SOC,N}^{charge-e}$ is the first-order internal resistance value at the moment of end of charging, $U_{t_{charge\_start}-1}$ is voltage at the moment just before the start of charging, $U_{t_{charge\_start}}$ is voltage at the moment of the start of charging, $U_{t_{charge\_end}}$ is voltage at the moment of the end of charging, $U_{t_{charge\_end+1}}$ is voltage at the moment just after the end of charging, $t_{chargestart-1}$ is the moment just before the start of charging, $t_{charge\_start}$ is the moment of the start of charging, $t_{charge\_end}$ is the moment of the end of charging, and $t_{drive\_start+1}$ is the moment just after the end of charging, I is the charging current.

The first-order internal resistance table of the driving process is acquired by the following steps:

calculating first-order internal resistance values of the driving process under different second initial state of charge, discharging current, number of cycles, and driving static voltage, wherein the driving static voltage is an average value of voltage in a state of stopping driving and voltage in a static state before driving;
establishing a second relationship table of the first-order internal resistance value of the driving process and the corresponding second initial state of charge, discharging current, number of cycles, and driving static voltage;
based on the total voltage and state of charge table, using the driving static voltage as the total voltage, and acquiring a second modified state of charge corresponding to the driving static voltage;
modifying the second initial state of charge in the second relational table to the second modified state of charge to obtain the first-order internal resistance table of the driving process.

The first-order internal resistance value of the driving process is calculated by the following formulas:

$$R_{I,SOC,N}^{drive-s} = \frac{U_{t_{drive\_start}-1} - U_{t_{drive\_start}}}{I}$$

$$R_{I,SOC,N}^{drive-e} = \frac{U_{t_{drive\_end}} - U_{t_{drive\_end}+1}}{I}$$

wherein, $R_{I,SOC,N}^{drive-s}$ is the first-order internal resistance value at the moment of start of driving, $R_{I,SOC,N}^{drive-e}$ is the first-order internal resistance value at the moment of end of driving, $U_{t_{drive\_start}-1}$ is voltage at the moment just before the start of driving, $U_{t_{drive\_start}}$ is voltage at the moment of the start of driving, $U_{t_{drive\_end}}$ is voltage at the moment of the end of driving, $U_{t_{drive\_end}+1}$ is the voltage at the moment just after the end of driving, $t_{drive\_start-1}$ is the moment just before the start of driving, $t_{drive\_start}$ is the moment of the start of driving, $t_{drive\_end}$ is the moment of the end of driving, $t_{drive\_end+1}$ is the moment just after the end of driving, I is the discharging current.

The charging capacity degradation rate is acquired by the following steps: determining the state of charge in a static state before the start of charging based on the battery cell voltage and state of charge table and the lowest battery cell voltage value in the static state before the start of charging; determining the state of charge in a static state after the end of charging based on the battery cell voltage and state of charge table and the highest battery cell voltage value in the static state at the end of charging; determining the moment of the static state before the start of charging and the moment of the static state after the end of charging based on the state of charge of the power battery at each moment; calculating the charging capacity degradation rate based on the moment of the static state before the start of charging and the moment of the static state after the end of charging.

The charging capacity degradation rate is calculated by the following formulas:

$$\begin{cases} Q_{SOC_{charge\_start}, SOC_{charge\_end}} = \int_{t_{SOC_{charge\_start}}}^{t_{SOC_{charge\_end}}} i(t)dt \\ Q_{now} = \dfrac{Q_{SOC_{charge\_start}, SOC_{charge\_end}}}{\Delta SOC} \\ SOH_{c1} = \dfrac{Q_{now}}{Q_{ini}} \times 100\% \end{cases}$$

wherein, $Q_{SOC_{charge\_start}, SOC_{charge-end}}$ is a cumulative capacity value from the moment of the static state before the start of charging to the moment of the static state after the end of charging, $SOC_{charge\_start}$ is the state of charge in the static state before the start of charging, $SOC_{charge\_end}$ is the state of charge in the static state after the end of charging, $t_{SOC_{charge\_start}}$ is the moment of the static state before the start of charging, $t_{SOC_{charge\_end}}$ is the moment of the static state at the end of charging, $Q_{now}$ is current maximum available capacity of the battery, $Q_{ini}$ is an initial maximum available capacity of the battery, and $SOH_{c1}$ is the charging capacity degradation rate, i is current.

The discharging capacity degradation rate is calculated by the following formula:

$$SOH_{c2} = \frac{M_{drive\_end} - M_{drive\_start}}{M_{NEDC}}$$

wherein, $SOH_{c2}$ is the discharging capacity degradation rate, $M_{drive\_end}$ is mileage at the end of driving, $M_{drive\_start}$ is mileage at the start of driving, $M_{NEDC}$ is mileage duration.

While embodiments of the present invention have been described above, the foregoing description is exemplary, not exhaustive, and is not limited to the disclosed embodiments. Many modifications and alterations will be apparent to those of ordinary skill in the art without departing from the scope and spirit of the described embodiments.

**Claims**

1. A battery capacity characteristic extraction method, **characterized in that** it comprises:

   acquiring state of charge, total voltage, a lowest battery cell voltage value and a highest battery cell voltage value at each moment in charging process and discharging process of a power battery when current is lower than a current threshold and a torque of a driving motor is lower than a torque threshold;
   acquiring a total voltage and state of charge table on the basis of the state of charge and the total voltage at each moment;
   acquiring a battery cell voltage and state of charge table on the basis of the state of charge, the lowest battery cell voltage value and the highest battery cell voltage value at each moment;
   acquiring a first-order internal resistance table of the charging process and a first-order internal resistance table of driving process on the basis of the total voltage and state of charge table; and
   acquiring charging capacity degradation rate on the basis of the battery cell voltage and state of charge table.

2. The battery capacity characteristic extraction method according to claim 1, **characterized in that** the total voltage and state of charge table is acquired by the following steps:

   drawing a first coordinate system with the state of charge as horizontal coordinate and the total voltage as vertical coordinate, and marking the state of charge and the total voltage at each moment in the first coordinate system;
   sequentially connecting marked points to obtain a first curve, fitting the first curve and acquiring the total voltage and state of charge table according to fitted relationship.

3. The battery capacity characteristic extraction method according to claim 2, **characterized in that** the battery cell voltage and state of charge table is acquired by the following steps:

   drawing a second coordinate system with the state of charge as horizontal coordinate and the battery cell voltage as vertical coordinate, and marking the state of charge, the lowest battery cell voltage value and the highest battery cell voltage value at each moment in the second coordinate system;
   sequentially connecting marked points to obtain a second curve, fitting the second curve and acquiring the battery cell voltage and state of charge table according to fitted relationship.

4. The battery capacity characteristic extraction method according to claim 3, **characterized in that** the first-order internal resistance table of the charging process is acquired by the following steps:

   calculating first-order internal resistance values of the charging process under different first initial state of charge, charging current, number of cycles, and charging static voltage, wherein the charging static voltage is an average value of voltage in a state of stopping charging or static state before charging;

establishing a first relationship table of the first-order internal resistance value of the charging process and the corresponding first initial state of charge, charging current, number of cycles, and charging static voltage;

based on the total voltage and state of charge table, using the charging static voltage as the total voltage, and acquiring a first modified state of charge corresponding to the charging static voltage;

modifying the first initial state of charge in the first relationship table to the modified state of charge to obtain the first-order internal resistance table of the charging process.

5. The battery capacity characteristic extraction method according to claim 4, **characterized in that**, the first-order internal resistance value of the charging process is calculated by the following formulas:

$$\begin{cases} R_{I,SOC,N}^{charge-s} = \dfrac{U_{t_{charge\_start}-1} - U_{t_{charge\_start}}}{I} \\ R_{I,SOC,N}^{charge-e} = \dfrac{U_{t_{charge\_end}} - U_{t_{charge\_end}+1}}{I} \end{cases}$$

wherein, $R_{I,SOC,N}^{charge-s}$ is the first-order internal resistance value at the moment of start of charging, $R_{I,SOC,N}^{charge-e}$ is the first-order internal resistance value at the moment of end of charging, $U_{t_{charge\_start}1}$ is voltage at the moment just before the start of charging, $U_{t_{charge\_start}}$ is voltage at the moment of the start of charging, $U_{t_{charge\_end}}$ is voltage at the moment of the end of charging, $U_{t_{charge\_end}+1}$ is voltage at the moment just after the end of charging, $t_{charge\_start-1}$ is the moment just before the start of charging, $t_{charge\_start}$ is the moment of the start of charging, $t_{charge\_end}$ is the moment of the end of charging, and $t_{charge\_end+1}$ is the moment just after the end of charging, I is the charging current.

6. The battery capacity characteristic extraction method according to claim 2, **characterized in that** the first-order internal resistance table of the driving process is acquired by the following steps:

calculating first-order internal resistance values of the driving process under different second initial state of charge, discharging current, number of cycles, and driving static voltage, wherein the driving static voltage is an average value of voltage in a state of stopping driving or static state before driving;

establishing a second relationship table of the first-order internal resistance value of the driving process and the corresponding second initial state of charge, discharging current, number of cycles, and driving static voltage;

based on the total voltage and state of charge table, using the driving static voltage as the total voltage, and acquiring a second modified state of charge corresponding to the driving static voltage;

modifying the second initial state of charge in the second relational table to the second modified state of charge to obtain the first-order internal resistance table of the driving process.

7. The battery capacity characteristic extraction method according to claim 1, **characterized in that** the first-order internal resistance value of the driving process is calculated by the following formulas:

$$R_{I,SOC,N}^{drive-s} = \dfrac{U_{t_{drive\_start}-1} - U_{t_{drive\_start}}}{I}$$

$$R_{I,SOC,N}^{drive-e} = \dfrac{U_{t_{drive\_end}} - U_{t_{drive\_end}+1}}{I}$$

wherein, $R_{I,SOC,N}^{drive-s}$ is the first-order internal resistance value at the moment of start of driving, $R_{I,SOC,N}^{drive-e}$ is the first-order internal resistance value at the moment of end of driving, $U_{t_{drive\_start}1}$ is voltage at the moment just before the start of driving, $U_{t_{drive\_start}}$ is voltage at the moment of the start of driving, $U_{t_{drive\_end}}$ is voltage at the moment of the end of driving, $U_{t_{drive\_end+1}}$ is voltage at the moment just after the end of driving, $t_{drive\_start-1}$ is the moment just before the start of driving, $t_{drive\_start}$ is the moment of the start of driving, $t_{drive\_end}$ is the moment of the end of driving, $t_{drive\_end+1}$ is the moment just after the end of driving, I is the discharging current.

8. The battery capacity characteristic extraction method according to claim 1, **characterized in that** the charging capacity degradation rate is acquired by the following steps:

> determining the state of charge in a static state before start of charging based on the battery cell voltage and state of charge table and the lowest battery cell voltage value in the static state before the start of charging;
> determining the state of charge in a static state after end of charging based on the battery cell voltage and state of charge table and the highest battery cell voltage value in the static state at the end of charging;
> determining the moment of the static state before the start of charging and the moment of the static state after the end of charging based on the state of charge of the power battery at each moment;
> calculating the charging capacity degradation rate based on the moment of the static state before the start of charging and the moment of the static state after the end of charging.

9. The battery capacity characteristic extraction method according to claim 8, **characterized in that** the charging capacity degradation rate is calculated by the following formulas:

$$
\begin{cases}
Q_{SOC_{charge\_start}, SOC_{charge\_end}} = \int_{t_{SOC_{charge\_start}}}^{t_{SOC_{charge\_end}}} i(t)dt \\
\\
Q_{now} = \dfrac{Q_{SOC_{charge\_start}, SOC_{charge\_end}}}{\Delta SOC} \\
\\
SOH_{c1} = \dfrac{Q_{now}}{Q_{ini}} \times 100\%
\end{cases}
$$

wherein, $Q_{SOC_{charge\_start}, SOC_{charge\_end}}$ is a cumulative capacity value from the moment of the static state before the start of charging to the moment of the static state after the end of charging, $SOC_{charge\_start}$ is the state of charge in the static state before the start of charging, $SOC_{charge\_end}$ is the state of charge in the static state after the end of charging, $t_{SOC_{charge\_start}}$ is the moment of the static state before the start of charging, $t_{SOC_{charge\_end}}$ is the moment of the static state at the end of charging, $Q_{now}$ is current maximum available capacity of the battery, $Q_{ini}$ is an initial maximum available capacity of the battery, and $SOH_{c1}$ is the charging capacity degradation rate, i is current.

10. The battery capacity characteristic extraction method according to claim 8, **characterized in that**, further comprising: the discharging capacity degradation rate is calculated by the following formula:

$$
SOH_{c2} = \frac{M_{drive\_end} - M_{drive\_start}}{M_{NEDC}}
$$

wherein, $SOH_{c2}$ is the discharging capacity degradation rate, $M_{drive\_end}$ is mileage at the end of driving, $M_{drive\_start}$ is mileage at the start of driving, $M_{NEDC}$ is mileage duration.

acquiring a state of charge, a total voltage, a lowest battery cell voltage value and a highest battery cell voltage value at each moment in a charging process and a discharging process of a power battery when current is lower than a current threshold and a torque of a driving motor is lower than a torque threshold — step 1

acquiring a total voltage and state of charge table on the basis of the state of charge and the total voltage at each moment — step 2

acquiring a battery cell voltage and state of charge table on the basis of the state of charge, the lowest battery cell voltage value and the highest battery cell voltage value at each moment — step 3

acquiring a first-order internal resistance table of the charging process and a first-order internal resistance table of a driving process on the basis of the total voltage and state of charge table — step 4

acquiring a charging capacity degradation rate on the basis of the battery cell voltage and state of charge table — step 5

Fig.1

Fig.2

Fig.3

Fig.4

## INTERNATIONAL SEARCH REPORT

| International application No. |
|---|
| **PCT/CN2022/097986** |

**A.    CLASSIFICATION OF SUBJECT MATTER**

G01R 31/392(2019.01)i;  G01R 31/36(2019.01)i

According to International Patent Classification (IPC) or to both national classification and IPC

**B.    FIELDS SEARCHED**

Minimum documentation searched (classification system followed by classification symbols)

G01R31/-

Documentation searched other than minimum documentation to the extent that such documents are included in the fields searched

Electronic data base consulted during the international search (name of data base and, where practicable, search terms used)

CNABS, CNTXT, VCN: 北京国家新能源汽车技术创新中心有限公司, 王辰, 王泽兴, 宗磊, 邹广才, 原诚寅, 荷电状态, SOC, 电压, OCV, 单体, 单个, 单节, 最高, 最大, 上限, 最低, 最小, 下限, 内阻, 阻抗, 阻值, 表, 曲线, 拟合, 充电, 放电, 驾驶, 行车, 行进, 行驶, 电动车, 电动汽车, 动力电池, 衰减, 衰退, SOH, 获取, 采样, 测量, 传感, 感测, 接收, 采集, 静态, 静止, 静置, 修正, 校正, 补偿. VEN, ENTXT, WPABS: state of charge, SOC, voltage, OCV, cell, single, maximum, upper, minimum, lower, internal resistance, impedance, table, curve, fit, charging, driving, electric vehicle, car, power, SOH, acquire, measure, static, station, correct, compensate, calibrate.

**C.    DOCUMENTS CONSIDERED TO BE RELEVANT**

| Category* | Citation of document, with indication, where appropriate, of the relevant passages | Relevant to claim No. |
|---|---|---|
| PX | CN 114089207 A (BEIJING NATIONAL NEW ENERGY VEHICLE TECHNOLOGY INNOVATION CENTER CO., LTD.) 25 February 2022 (2022-02-25)<br>description, paragraphs 0001-0110, and figures 1-4 | 1-10 |
| Y | CN 108761338 A (KINGLONG UNITED AUTOMOTIVE INDUSTRY (SUZHOU) CO., LTD.) 06 November 2018 (2018-11-06)<br>description, paragraphs 0033-0051, and figures 1-3 | 1-3, 7-10 |
| Y | CN 109557477 A (ZHENGZHOU YUTONG BUS CO., LTD.) 02 April 2019 (2019-04-02)<br>description, paragraphs 0026-0039 | 1-3, 7-10 |
| A | CN 113253140 A (HANGZHOU KEH ELECTRONIC TECHNOLOGY CO. LTD.) 13 August 2021 (2021-08-13)<br>entire document | 1-10 |
| A | WO 2013031558 A1 (SANYO ELECTRIC CO., LTD. et al.) 07 March 2013 (2013-03-07)<br>entire document | 1-10 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **24 August 2022** | **21 September 2022** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2022/097986**

### C.    DOCUMENTS CONSIDERED TO BE RELEVANT

| Category* | Citation of document, with indication, where appropriate, of the relevant passages | Relevant to claim No. |
|---|---|---|
| A | CN 108663620 A (BYD CO., LTD.) 16 October 2018 (2018-10-16)<br>entire document | 1-10 |
| A | CN 111896882 A (NINGBO GEELY AUTOMOBILE RESEARCH AND DEVELOPMENT CO., LTD. et al.) 06 November 2020 (2020-11-06)<br>entire document | 1-10 |
| A | US 2020164763 A1 (QUANTUMSCAPE CORP.) 28 May 2020 (2020-05-28)<br>entire document | 1-10 |
| A | JP 2016156771 A (RITSUMEIKAN) 01 September 2016 (2016-09-01)<br>entire document | 1-10 |
| A | CN 111273185 A (ZHENGZHOU YUTONG BUS CO., LTD.) 12 June 2020 (2020-06-12)<br>entire document | 1-10 |

Form PCT/ISA/210 (second sheet) (January 2015)

**INTERNATIONAL SEARCH REPORT**
Information on patent family members

International application No.

**PCT/CN2022/097986**

| Patent document cited in search report | | | Publication date (day/month/year) | Patent family member(s) | | | Publication date (day/month/year) |
|---|---|---|---|---|---|---|---|
| CN | 114089207 | A | 25 February 2022 | None | | | |
| CN | 108761338 | A | 06 November 2018 | KR | 20200096608 | A | 12 August 2020 |
| | | | | WO | 2019223258 | A1 | 28 November 2019 |
| | | | | CN | 108761338 | B | 22 May 2020 |
| CN | 109557477 | A | 02 April 2019 | CN | 108663620 | B | 31 March 2020 |
| CN | 113253140 | A | 13 August 2021 | CN | 113253140 | B | 28 September 2021 |
| WO | 2013031558 | A1 | 07 March 2013 | JP | 2014211307 | A | 13 November 2014 |
| CN | 108663620 | A | 16 October 2018 | CN | 108663620 | B | 31 March 2020 |
| CN | 111896882 | A | 06 November 2020 | None | | | |
| US | 2020164763 | A1 | 28 May 2020 | WO | 2019017991 | A1 | 24 January 2019 |
| JP | 2016156771 | A | 01 September 2016 | JP | 6238314 | B2 | 29 November 2017 |
| CN | 111273185 | A | 12 June 2020 | None | | | |

Form PCT/ISA/210 (patent family annex) (January 2015)